# EUROPEAN PATENT APPLICATION

(11) **EP 4 750 080 A1**
(43) Date of publication of application: **27.05.2026**
(21) Application number: 24940932.7
(22) Date of filing: 22.08.2024
(51) Int. Cl.: H04R 1/10

(54) **EARPHONE**

(71) Applicant: Shenzhen Shokz Co., Ltd., Shenzhen, Guangdong 518108 (CN)
(72) Inventor: LI, Chaowu, Shenzhen, Guangdong 518108 (CN); NIE, Qianwen, Shenzhen, Guangdong 518108 (CN); WANG, Chong, Shenzhen, Guangdong 518108 (CN); KE, Hao, Shenzhen, Guangdong 518108 (CN)
(74) Representative: Wang, Bo
(86) International application number: PCT/CN2024/114012
(87) International publication number: WO 2026/040056

(57) **Abstract**

The present disclosure relates to an earphone. The earphone includes an antenna including a radiator arranged in a ring shape and a feed point disposed on the radiator, the feed point being configured to receive a feed current, wherein the feed current forms a first transmission current and a second transmission current that are transmitted in opposite directions along a circumferential direction of the radiator on two sides of the feed point, and the first transmission current and the second transmission current converge in the radiator. In this way, a SAR value can be reduced, and an impact of electromagnetic wave in the earphone on a human body can be reduced.

## Description

### TECHNICAL FIELD

The present disclosure relates to the field of electronic device, and in particular, to an earphone.

### BACKGROUND

With the continuous popularization of electronic devices, the electronic devices have become indispensable social and entertainment tools in people's daily lives, and people's requirements for the electronic devices also have increasingly higher. Electronic devices such as earphones and smart glasses have also been widely used in people's daily lives. The electronic devices can be used in conjunction with terminal devices such as mobile phones and computers to provide users with an auditory feast.

Nowadays, an earphone is usually equipped with a touch circuit or a touch module to detect whether the earphone is worn into an ear, but a wearing detection function of the current earphone is not sensitive, so that the user often experiences accidental touch when removing or touching the earphone, resulting in an earphone judgment error, which affects the user's wearing experience.

### SUMMARY

To solve the above technical problem, one technical solution adopted by the present disclosure is to provide an earphone. The earphone includes an ear hook and a sound production portion connected to each other, wherein in a wearing state, the ear hook is hooked between an auricle and a head of a user, and the sound production portion is located at an anterior side of the auricle; the sound production portion includes a core housing and a first capacitance plate, the core housing including a connection end connected to the ear hook and a free end away from the connection end, wherein at least a portion of the free end extends into a concha cavity or abuts against the auricle; the first capacitance plate is disposed inside the core housing and at least a portion of the first capacitance plate is located at the free end; and the first capacitance plate is configured to detect whether the earphone is in the wearing state; and the core housing has a length direction, a width direction, and a thickness direction that are orthogonal to each other, the thickness direction being a direction in which the core housing faces toward or away from the auricle in the wearing state, the length direction being a direction in which the core housing is close to or far away from a back of the head in the wearing state, wherein the first capacitance plate forms a first projection in a first reference plane perpendicular to the thickness direction; and the first projection is located within a 5 equally divided region of the core housing that is closest to the free end along the length direction.

In some embodiments, the first projection is located within a 7 equally divided region of the core housing that is closest to the free end along the length direction.

In some embodiments, in the wearing state, at least a portion of the free end abuts against a helix of the auricle or an antihelix of the auricle.

In some embodiments, the first capacitance plate has a maximum distance from an outermost end of the free end along the length direction; and a ratio of the maximum distance to an entire length of the core housing along the length direction is less than or equal to 0.2, the entire length being a distance from the free end to the connection end of the core housing.

In some embodiments, the core housing includes a first side wall and a second side wall arranged at an interval along the thickness direction, wherein the first side wall is closer to the auricle than the second side wall in the wearing state; the first capacitance plate includes a first main portion, a second main portion, and a connecting portion, wherein the second main portion is arranged at an interval from the first main portion along the thickness direction, the second main portion is closer to the first side wall; and the connecting portion connects the first main portion and the second main portion, and is bent such that the first main portion and the second main portion are arranged non-coplanar.

In some embodiments, the first capacitance plate forms a second projection in a second reference plane perpendicular to the length direction, wherein the first projection includes a first sub-projection area formed by the first main portion and a second sub-projection area formed by the second main portion; and the second projection includes a third sub-projection area formed by the first main portion and a fourth sub-projection area formed by the second main portion, wherein an area of the first sub-projection area is less than an area of the third sub-projection area, and an area of the second sub-projection area is less than an area of the fourth sub-projection area.

In some embodiments, an annular flange is disposed on a side wall surface of the first side wall that is close to the first capacitance plate; the earphone further includes a speaker and a sound cavity bracket disposed inside the core housing; the annular flange and the speaker cooperate to form an acoustic front cavity; the sound cavity bracket and the speaker cooperate to form an acoustic rear cavity; the first main portion is fixed on an outer circumferential surface of the sound cavity bracket; and the second main portion is fixed on an outer circumferential surface of the annular flange.

In some embodiments, the first main portion includes at least two first sub-main portions circumferentially bent and connected along a circumference of the sound cavity bracket, and/or the second main portion includes at least two second sub-main portions circumferentially bent and connected along a circumference of the annular flange.

In some embodiments, when the first reference plane is translated along the thickness direction, the first reference plane and the first main portion form a first intersection line, wherein along a direction from the second side wall toward the first side wall, a length of the first intersection line becomes longer.

In some embodiments, when the first reference plane is translated along the thickness direction, the first reference plane and the second main portion form a second intersection line, wherein a minimum length of the second intersection line is not less than a minimum length of the first intersection line.

In some embodiments, a minimum length of the second intersection line is not less than a maximum length of the first intersection line.

In some embodiments, the earphone further includes a second capacitance plate disposed on the second side wall, the second capacitance plate being configured to generate a touch signal in response to a touch operation of a user, wherein a spatial distance between the first capacitance plate and the second capacitance plate along the length direction is not less than 4 mm.

Beneficial effects of the present disclosure are as follows. The present disclosure disposes the first capacitance plate in the core housing of the earphone, and the core housing includes the free end and the connection end arranged along the length direction, wherein the free end extends into the concha cavity or abuts against the auricle, and the first capacitance plate is disposed within the 5 equally divided region of the core housing that is closest to the free end along the length direction. Such a configuration enables the first capacitance plate to be closer to a wall of the concha cavity or a position close to the auricle, so that the first capacitance plate can detect whether the free end extends into the concha cavity or abuts against the user's auricle more accurately, which can reduce the accidentally touching phenomenon when the user picks up the earphone, thereby reducing a probability of accident touch, so that the first capacitance plate can detect whether the earphone is in the wearing state more accurately, thereby improving the wearing experience of the user.

### BRIEF DESCRIPTION OF THE DRAWINGS

FIG. 1 is a schematic diagram illustrating a contour of an anterior side of an ear of a user according to the present disclosure;
FIG. 2 is a schematic diagram illustrating a three-dimensional structure of one side of an earphone according to some embodiments of the present disclosure;
FIG. 3 is a schematic diagram illustrating the earphone shown in FIG. 2 in a wearing state;
FIG. 4 is a schematic diagram illustrating a three-dimensional structure of one side of a sound production portion in the earphone shown in FIG. 2;
FIG. 5 is a schematic diagram illustrating an exploded structure of the sound production portion shown in FIG. 4;
FIG. 6 is a schematic diagram illustrating a cross-sectional structure of the sound production portion shown in FIG. 4 along a section line A-A;
FIG. 7 is a schematic diagram illustrating a structure of some components in the sound production portion shown in FIG. 4 viewed along a thickness direction;
FIG. 8 is a schematic diagram illustrating a structure of a first capacitance plate of the sound production portion shown in FIG. 4 viewed along a thickness direction;
FIG. 9 is a structural schematic diagram illustrating the first capacitance plate of the sound production portion shown in FIG. 4 viewed along a length direction;
FIG. 10 is another schematic diagram illustrating an exploded structure of the sound production portion shown in FIG. 4;
FIG. 11 is another schematic diagram illustrating an exploded structure of the sound production portion shown in FIG. 4;
FIG. 12 is another schematic diagram illustrating an exploded structure of the sound production portion shown in FIG. 4; and
FIG. 13 is an enlarged schematic diagram illustrating a partial region C of the sound production portion shown in FIG. 11.

### DETAILED DESCRIPTION

Embodiments of the present disclosure are described in detail below in conjunction with the accompanying drawings. Technical solutions in the embodiments of the present disclosure are described clearly and completely. Obviously, the described embodiments are only a part of the embodiments of the present disclosure, rather than all of the embodiments. Based on the embodiments of the present disclosure, all other embodiments obtained by a person of ordinary skill in the art without creative efforts fall within the scope of protection of the present disclosure.

The mention of "embodiment" in the present disclosure means that a specific feature, structure, or characteristic described in connection with the embodiment may be included in at least one embodiment of the present disclosure. A person skilled in the art explicitly and implicitly understands that the embodiments described in the present disclosure may be combined with other embodiments.

The following is an exemplary description of an earphone according to some embodiments of the earphone.

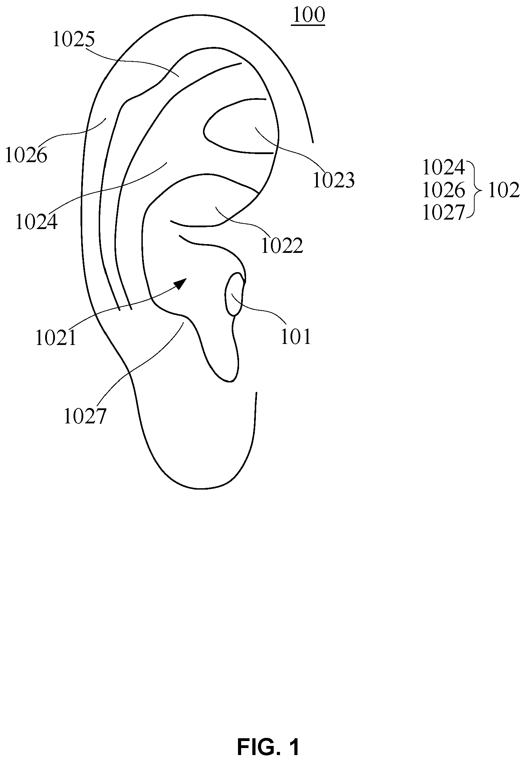

In conjunction with FIG. 1, an ear 100 of a user may include an external acoustic meatus 101 and an auricle 102. The auricle 102 may include physiological parts such as an antihelix 1024, a helix 1026, and a tragus 1027. The auricle 102 may form a concha cavity 1021, a cymba concha 1022, a triangular fossa 1023, and a scapha 1025. Although the external acoustic meatus 101 has a certain depth and extends to an eardrum of the ear 100, for ease of description, the external acoustic meatus 101 in the present disclosure specifically refers to an entrance (i.e., an ear hole) thereof facing away from the eardrum, unless otherwise specified. In addition, the concha cavity 1021, the cymba concha 1022, and the triangular fossa 1023 have a certain volume and depth, and the concha cavity 1021 is in direct communication with the external acoustic meatus 101, which can be simply considered that the aforementioned ear hole is located at a bottom of the concha cavity 1021.

An earphone 1 is an audio transducer, which can receive an electrical signal from a media player or a receiver and convert the electrical signal into a sound wave that can be heard by a user. In some embodiments, the earphone 1 may be an open earphone (e.g., an ear-hook earphone, a behind-the-neck earphone, an ear-clip earphone, etc.).

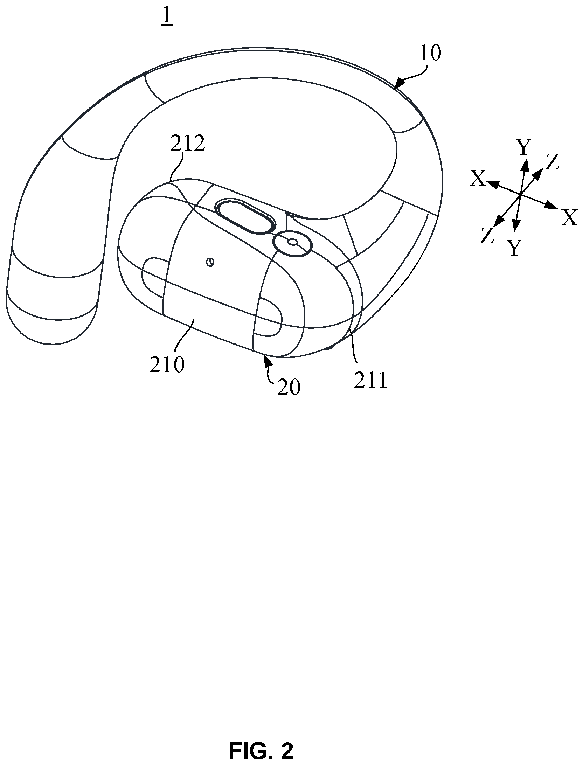

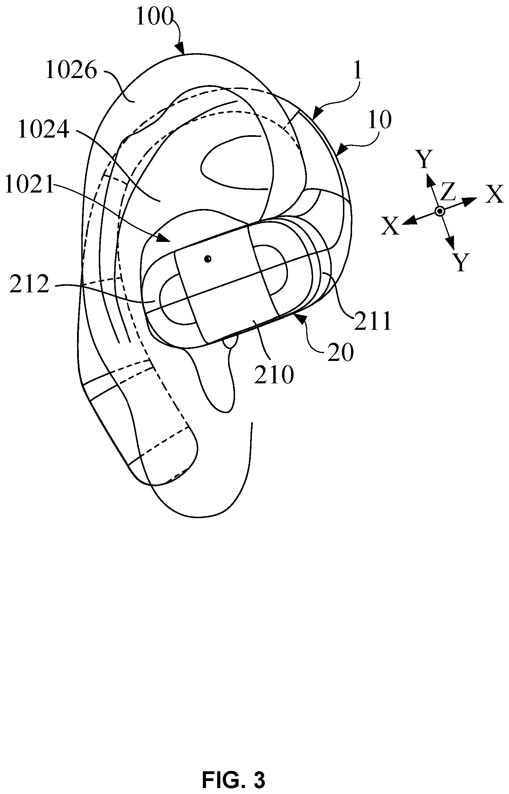

As shown in FIG. 2 and FIG. 3, the earphone 1 may be an ear-hook earphone. In some embodiments, in a wearing state, at least a portion of the earphone 1 may be inserted into the concha cavity 1021 of a user to improve wearing stability. In some embodiments, at least a portion of a sound production portion 20 of the earphone 1 may cover the auricle 102 (e.g., the antihelix 1024, the cymba concha 1022, the triangular fossa 1023, etc.) of the ear 100 of the user, and does not block the external acoustic meatus 101 of the ear 100 of the user or visually block the external acoustic meatus 101 of the ear 100 of the user. In some embodiments, the sound production portion 20 of the earphone 1 may also abut against a position of the helix 1026. In some embodiments, the sound production portion 20 of the earphone 1 may also attach to or abut against a facial area in front of an ear of the user, and a side of the sound production portion 20 for producing sound faces the ear of the user or faces the external acoustic meatus 101 of the user.

Furthermore, different users may have individual differences, resulting in dimensional differences in the ear 100 such as different shapes and sizes. For ease of description and to reduce (or even eliminate) the individual differences of the different users, a simulator including a head and ears 100 (a left ear and a right ear) thereof may be manufactured based on ANSI: S3.36, S3.25 standard and IEC: 60318-7 standard, such as GRAS 45BC KEMAR series, HEAD Acoustics series, B&K 4128 series, or a B&K 5128 series, to present a scenario where most users wear the earphone 1. Taking GRAS KEMAR as an example, the simulator for the ear 100 may be any one of GRAS45AC, GRAS 45BC, GRAS 45CC, GRAS 43AG, etc. Taking HEAD Acoustics as an example, the simulator for the ear 100 may be any one of HMS II.3, HMS II.3 LN, an HMSII.3LN HEC, etc. Therefore, in the present disclosure, descriptions such as "a user wears the earphone 1," "the earphone 1 is in a wearing state," and "in the wearing state," may refer to the earphone 1 described in the present disclosure being worn on the ear 100 of the aforementioned simulator. Certainly, precisely because different users have individual differences, there may be certain differences when the earphone 1 is worn by different users compared with when the earphone 1 is worn on the ear 100 of the aforementioned simulator, but such differences should be tolerated.

It should be noted that in fields such as medicine and anatomy, three basic planes (e.g., a sagittal plane, a coronal plane, and a horizontal plane) and three basic axes (e.g., a sagittal axis, a coronal axis, and a vertical axis) of a human body may be defined. The sagittal plane refers to a plane perpendicular to the ground made along an anteroposterior direction of a body, which divides the human body into a left part and a right part. The coronal plane refers to a plane perpendicular to the ground made along a left-right direction of the body, which divides the human body into a front part and a rear part. The horizontal plane refers to a plane parallel to the ground made along an up-and-down direction of the body, which divides the human body into an upper part and a lower part. Correspondingly, the sagittal axis refers to an axis along the anteroposterior direction of the body and perpendicular to the coronal plane. The coronal axis refers to an axis along the left-right direction of the body and perpendicular to the sagittal plane. The vertical axis refers to an axis along the up-and-down direction of the body and perpendicular to the horizontal plane. Furthermore, "an anterior side of the ear" described in the present disclosure is a concept relative to "a rear side of the ear." The former refers to a side of the ear away from the head, the latter refers to a side of the ear facing the head, and both are relative to the ear 100 of the user or the simulator. The ear 100 of the human body or the aforementioned simulator observed along a direction of the coronal axis may be shown in FIG. 1.

Merely by way of example, in conjunction with FIG. 2 and FIG. 3, the earphone 1 may include an ear hook 10 and a sound production portion 20 connected to each other. In the wearing state, the ear hook 10 may be hooked between the auricle 102 and a head of the user. That is, at least a portion of the ear hook 10 of the earphone 1 may be located at a rear side of the ear 100, which allows the earphone 1 to be hooked on the ear 100 and the sound production portion 20 to be located at an anterior side of the auricle 102. The sound production portion 20 may be a sound playback device. The sound production portion 20 may be configured to convert an electrical signal into an acoustic signal (also referred to as a "sound wave" or a "sound signal") and propagate the acoustic signal to the ear 100 of a wearer.

In some embodiments, a battery, a circuit board, or other components may be disposed in the ear hook 10, or both a battery and a circuit board may be disposed in the ear hook 10. Certainly, the battery, the circuit board, or other components may not be disposed in the ear hook 10, and the battery, the circuit board, or other components may be installed in the sound production portion 20.

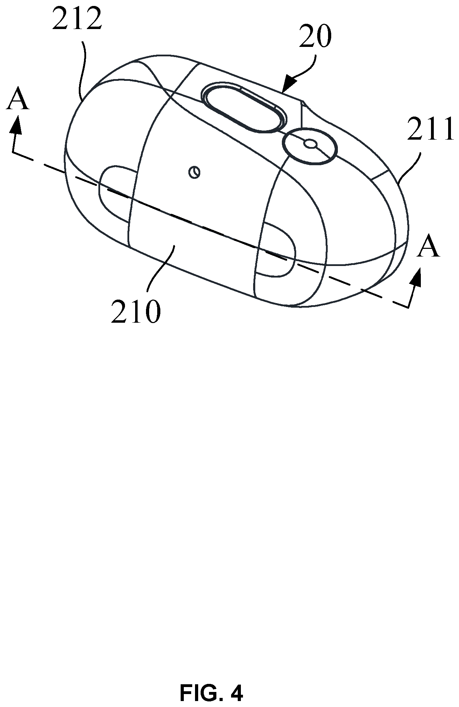

In some embodiments, as shown in FIG. 2 to FIG. 6, the sound production portion 20 may include a core housing 210 and a first capacitance plate 220.

The core housing 210 may include a connection end 211 connected to the ear hook 10 and a free end 212 away from the connection end 211, and at least a portion of the free end 212 may extend into the concha cavity 1021 or abut against the auricle 102 of the user. The first capacitance plate 220 may be disposed inside the core housing 210 and at least a portion of the first capacitance plate 220 is located at the free end 212 of the core housing 210, and the first capacitance plate 220 is configured to detect whether the earphone 1 is in the wearing state.

In some embodiments, in the wearing state, at least a portion of the free end 212 may extend into the concha cavity 1021. The first capacitance plate 220 disposed at the free end 212 may detect whether the free end 212 is in contact with an inner wall of the concha cavity 1021 or detect whether a portion of the free end 212 accommodating the first capacitance plate 220 is close to the inner wall of the concha cavity 1021 to a certain threshold, thereby detecting whether the earphone 1 is in the wearing state.

In other embodiments, in the wearing state, at least a portion of the free end 212 may abut against the auricle 102 of the user. For example, at least a portion of the free end 212 may abut against the helix 1026 of the auricle 102 or abut against the antihelix 1024. The first capacitance plate 220 disposed at the free end 212 may detect whether the free end 212 is in contact with the auricle 102 (e.g., the helix 1026 or the antihelix 1024) of the user or detect whether the portion of the free end 212 accommodating the first capacitance plate 220 is close to the auricle 102 (e.g., the helix 1026 or the antihelix 1024) of the user to the certain threshold, thereby detecting whether the earphone 1 is in the wearing state.

The certain threshold refers to a shortest distance between the portion of the free end 212 accommodating the first capacitance plate 220 and the inner wall of the concha cavity 1021 or the auricle 102 (e.g., the helix 1026 or the antihelix 1024) of the user. Merely by way of example, the certain threshold may be between 0 mm and 1 mm. That is, when a distance between the first capacitance plate 220 and the inner wall of the concha cavity 1021 or the auricle 102 (e.g., the helix 1026 or the antihelix 1024) of the user is close to 1 mm or less than 1 mm, the first capacitance plate 220 inside the free end 212 may correspondingly detect that the earphone 1 is in the wearing state.

In some embodiments, the certain threshold may be 0 mm to 0.5 mm, 0 mm to 0.7 mm, or 0 mm to 2 mm. That is, when a distance between the portion of the free end 212 accommodating the first capacitance plate 220 and the inner wall of the concha cavity 1021 or the auricle 102 (e.g., the helix 1026 or the antihelix 1024) of the user is less than or equal to 2 mm, 0.7 mm, or 0.5 mm, the first capacitance plate 220 inside the free end 212 may correspondingly detect that the earphone 1 is in the wearing state.

In some embodiments, the first capacitance plate 220 may be a chip capacitance plate, which is a conversion element configured to convert a mechanical quantity (e.g., a resistance value change, a pressure change, etc.) upon contact with a human body into a capacitance change, thereby determining whether the earphone 1 is in the wearing state. In some embodiments, the first capacitance plate 220 may be a conversion element configured to convert a distance change between the first capacitance plate 220 and a target (the inner wall of the concha cavity 1021 or the auricle 102 of the user) into the capacitance change, thereby determining whether the earphone 1 is in the wearing state based on the capacitance change of the first capacitance plate 220.

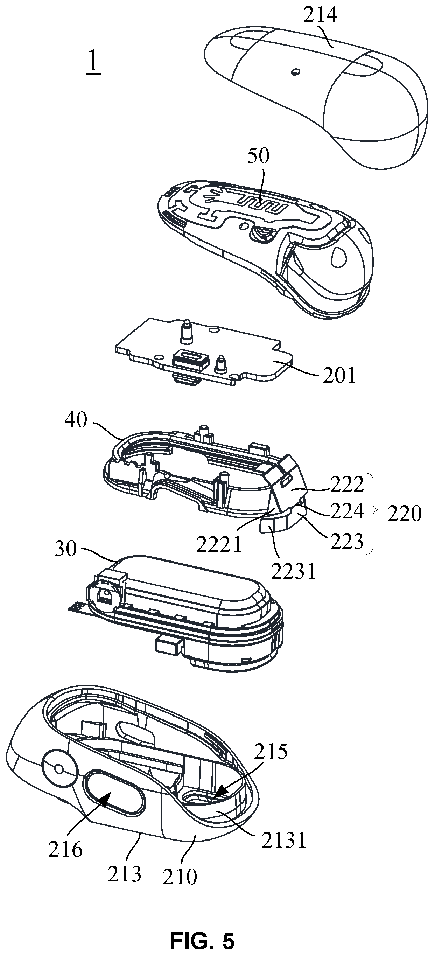

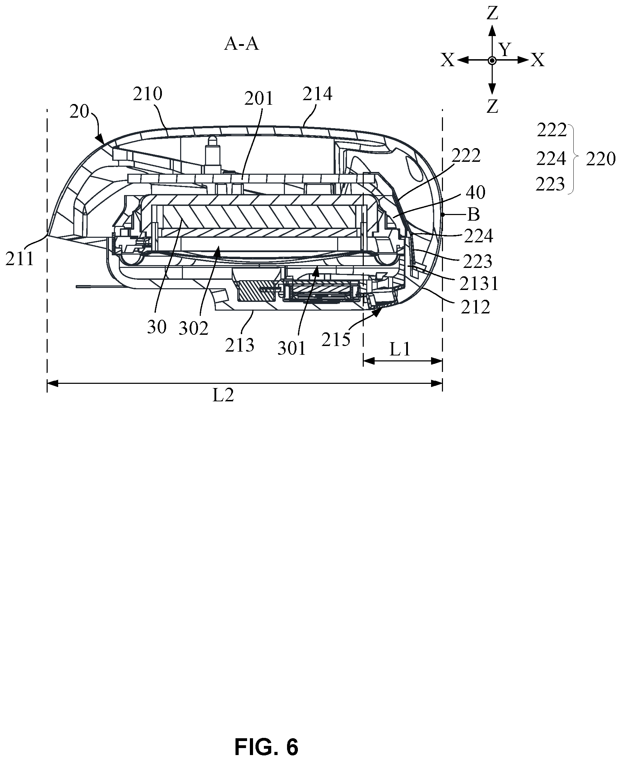

In some embodiments, as shown in FIG. 5 and FIG. 6, the earphone 1 may include a main control circuit board 201 disposed inside the core housing 210, and the first capacitance plate 220 may be electrically connected to the main control circuit board 201. An electrical signal generated by the first capacitance plate 220 may be transmitted to the main control circuit board 201, and the main control circuit board 201 may further regulate the earphone 1 based on the electrical signal of the first capacitance plate 220.

In some embodiments, as shown in FIG. 6, the first capacitance plate 220 may be entirely located inside the core housing 210. When the free end 212 of the core housing 210 is in contact with or close to the concha cavity 1021 or the auricle 102 of the user, a capacitance value of the first capacitance plate 220 inside the core housing 210 changes, so that the first capacitance plate 220 may detect that the earphone 1 is in the wearing state. Such a configuration can protect the first capacitance plate 220 from friction damage by the core housing 210, also facilitate formation of the core housing 210, reduce process difficulty, and reduce a possibility of accidentally touching of the first capacitance plate 220 simultaneously.

Certainly, in other embodiments, a portion of the first capacitance plate 220 may be located inside the core housing 210, and other portions of the first capacitance plate 220 may be disposed outside the core housing 210. Alternatively, the first capacitance plate 220 may be entirely disposed outside the core housing 210. The first capacitance plate 220 exposed outside the core housing 210 may be wrapped only by a flexible covering layer, thereby being in contact with or close to the concha cavity 1021 or the auricle 102 of the user, so as to detect whether the earphone 1 is in the wearing state. Such a configuration can improve detection sensitivity of the first capacitance plate 220 and ensure accuracy of wearing detection.

In some embodiments, the core housing 210 has a length direction, a width direction, and a thickness direction that are orthogonal to each other.

The length direction is a spatial direction between the connection end 211 and the free end 212. The spatial direction of the connection end 211 and the free end 212 refers to an extension direction of a line between the connection end 211 and the free end 212. In some embodiments, the connection end 211 and the free end 212 may have an irregular or regular arc shape, and the extension direction of the line between the connection end 211 and the free end 212 refers to a direction defined by a straight-line perpendicular to parallel tangent planes of two reference points with a farthest relative distance on the connection end 211 and the free end 212. The length direction may also be defined as a direction in which the core housing 210 is close to or far away from a back of a head in the wearing state. Merely by way of example, the length direction may be a direction shown by an arrow X in FIG. 2 to FIG. 7.

The width direction may be defined as a direction in which the core housing 210 is close to or far away from a top of the head in the wearing state. Merely by way of example, the width direction may be a direction shown by an arrow Y in FIG. 2 to FIG. 7.

The thickness direction may be a direction in which the core housing 210 faces towards or is far away from the auricle 102 in the wearing state. Merely by way of example, the thickness direction may be a direction shown by an arrow Z in FIG. 2 to FIG. 7. The thickness direction Z may be substantially parallel to a vibration direction of a speaker assembly in the sound production portion 20, wherein "substantially parallel to" means that a spatial angle between two directions is less than 5°.

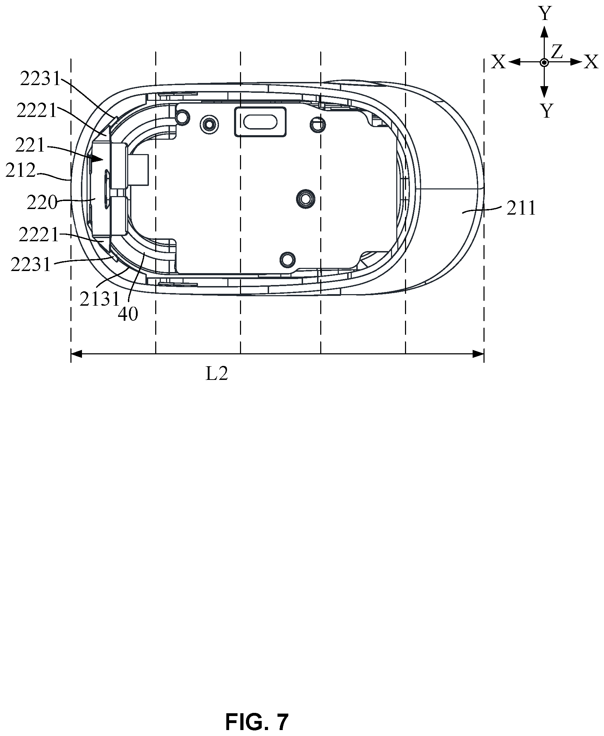

In some embodiments, as shown in FIG. 7, the first capacitance plate 220 may form a first projection 221 in a first reference plane perpendicular to the thickness direction Z, and the first projection 221 is located within a 5 equally divided region of the core housing 210 that is closest to the free end 212 along the length direction X. In other words, the core housing 210 may be divided into 5 equal parts along the length direction X, and the first capacitance plate 220 is disposed within a 1/5 region of the core housing 210 that is closest to the free end 212. Such a configuration enables the first capacitance plate 220 to be disposed closer to the free end 212, which improves accuracy of wearing detection and does not occupy much space of the core housing 210 in the length direction X.

If the first capacitance plate 220 extends too much into a region between the free end 212 and the connection end 211 along the length direction X, especially a region near a middle position of the core housing 210, the user is prone to experiencing the accidentally touching phenomenon of wearing detection when picking up the earphone 1. Merely by way of example, if the first capacitance plate 220 extends too much into the middle region of the core housing 210 along the length direction X, when the user pinches a middle position between the free end 212 and the connection end 211 for wearing, the first capacitance plate 220 is easily triggered, which causes the first capacitance plate 220 to falsely detect that the earphone 1 is in the wearing state and affects wearing experience of the user.

Therefore, disposing the first capacitance plate 220 in the 5 equally divided region of the core housing 210 that is closest to the free end 212 along the length direction X, can avoid the accidentally touching phenomenon as much as possible when the user picks up the earphone 1, which enables the first capacitance plate 220 to detect whether the free end 212 extends into the concha cavity 1021 or abuts against the auricle 102 of the user more accurately. Thus, the first capacitance plate 220 can detect whether the earphone 1 is in the wearing state more accurately, thereby improving wearing experience of the user.

In some embodiments, the first projection 221 may be located within a 7 equally divided region of the core housing 210 that is closest to the free end 212 along the length direction X. In other words, the core housing 210 may be divided into 7 equal parts along the length direction X, and the first capacitance plate 220 is disposed within a 1/7 region of the core housing 210 that is closest to the free end 212. Such a configuration allows a detection region corresponding to the first capacitance plate 220 to be more concentrated at the free end 212, which can further reduce the accidentally touching phenomenon of the first capacitance plate 220 when the user touches other positions rather than the free end 212. Thus, a detection result of the first capacitance plate 220 can be more accurate, thereby improving wearing experience of the user.

In other embodiments, to further improve detection accuracy of the first capacitance plate 220, the first projection 221 may also be located within an 8 equally divided region or a 9 equally divided region of the core housing 210 that is closest to the free end 212 along the length direction X.

In some embodiments, as shown in FIG. 6, the first capacitance plate 220 may have a maximum distance from an outermost end of the free end 212 along the length direction X, and a ratio of the maximum distance to an entire length of the core housing 210 along the length direction X is less than or equal to 0.2.

The entire length may be a farthest distance from the free end 212 to the connection end 211 of the core housing 210 along the length direction X, or the entire length may be a length of a straight-line segment perpendicular to parallel tangent planes of two reference points with a farthest relative distance on the connection end 211 and the free end 212. The outermost end of the free end 212 refers to a point on the free end 212 that is farthest from the connection end 211 along the length direction X, or when the free end 212 has a regular arc shape, the outermost end of the free end 212 may be a midpoint position of a projection of the arc-shaped free end on a plane perpendicular to the thickness direction Z.

Merely by way of example, the outermost end of the free end 212 may be a point B shown in FIG. 6, the maximum distance of the first capacitance plate 220 from the outermost end of the free end 212 along the length direction X may be a distance L1 shown in FIG. 6, and the entire length of the core housing 210 may be a distance L2 shown in FIG. 6, wherein L1:L2≤0.2.

Merely by way of example, the entire length L2 of the core housing 210 may be between 25 mm and 35 mm, and the maximum distance L1 may be between 4 mm and 7 mm. For example, the entire length of the core housing 210 may be 26 mm, 28 mm, 30 mm, etc. The maximum distance L1 may be 4 mm, 5 mm, 6 mm, etc. A ratio of the maximum distance L1 to the entire length L2 of the core housing 210 along the length direction X may be 0.15, 0.17, 0.2, etc.

If the ratio of the maximum distance to the entire length of the core housing 210 along the length direction X is greater than 0.2, the first capacitance plate 220 occupies too much space on the core housing 210 along the length direction X, the detection region corresponding to the first capacitance plate 220 diffuses too much to a position between the free end 212 and the connection end 211, so that the condition of accidentally touching the first capacitance plate 220 is increased, which reduces detection accuracy and detection sensitivity of the first capacitance plate 220. Thus, setting the ratio of the maximum distance to the entire length of the core housing 210 along the length direction X to be less than or equal to 0.2, enables the detection region corresponding to the first capacitance plate 220 to be more concentrated at the free end 212, which further reduces the condition of accidentally touching the first capacitance plate 220, thereby improving detection accuracy of the first capacitance plate 220.

In some embodiments, as shown in FIG. 5 and FIG. 6, the core housing 210 may include a first side wall 213 and a second side wall 214 arranged at an interval along the thickness direction Z, wherein the first side wall 213 is closer to the auricle 102 than the second side wall 214 in the wearing state. The first capacitance plate 220 may include a first main portion 222, a second main portion 223, and a connecting portion 224. The second main portion 223 may be arranged at an interval from the first main portion 222 along the thickness direction Z, and the second main portion 223 may be closer to the first side wall 213. The connecting portion 224 connects the first main portion 222 and the second main portion 223, and may be bent such that the first main portion 222 and the second main portion 223 are arranged non-coplanar.

Specifically, since the first side wall 213 is closer to the auricle 102 than the second side wall 214 in the wearing state, disposing the second main portion 223 closer to the first side wall 213 facilitates the first capacitance plate 220 to detect whether the free end 212 is in contact with or close to an inner wall of the concha cavity 1021 or the auricle 102 of the user, thereby facilitating determination of whether the earphone 1 is in the wearing state.

Furthermore, under the connection effect of the connecting portion 224, the setting of the first main portion 222 and the second main portion 223 being arranged non-coplanar, can increase a setting area of the first capacitance plate 220 within a limited internal space of the core housing 210, thereby improving detection accuracy and detection sensitivity of the wearing state of the earphone 1.

In some embodiments, as shown in FIG. 6, the first main portion 222 and the second main portion 223 may be arranged non-coplanar to adapt to a shape of the free end 212 of the core housing 210. Merely by way of example, the free end 212 may have an arc shape or a rounded rectangular shape, and the first main portion 222 and the second main portion 223 may be curved corresponding to the arc-shaped free end 212, so that the first main portion 222 and the second main portion 223 can be disposed as close as possible to the free end 212 of the core housing 210, thereby improving detection sensitivity and accuracy of the first main portion 222 and the second main portion 223.

In some embodiments, as shown in FIG. 5 and FIG. 6, an annular flange 2131 may be disposed on a side wall surface of the first side wall 213 that is close to the first capacitance plate 220, and the earphone 1 may further include a speaker 30 and a sound cavity bracket 40 disposed inside the core housing 210. Merely by way of example, the speaker 30 may be an air conduction speaker 30, and the sound cavity bracket 40 may support and fix the speaker 30 inside the core housing 210.

The annular flange 2131 and the speaker 30 may cooperate to form an acoustic front cavity 301, and the sound cavity bracket 40 and the speaker 30 may cooperate to form an acoustic rear cavity 302. Sound waves generated by the speaker 30 may propagate to the outside through the acoustic front cavity 301 and a sound outlet hole 215 on the core housing 210. As shown in FIG. 5, a pressure relief hole 216 may be disposed on the core housing 210, and the acoustic rear cavity 302 communicates with the outside through the pressure relief hole 216. With such a configuration, air pushed by a rear side of a diaphragm 321 can flow from the acoustic rear cavity 302 to the outside of the core housing 210, thereby preventing pressure accumulation in the acoustic rear cavity 302 from affecting sound quality of the speaker 30 as much as possible.

Specifically, the first main portion 222 may be fixed on an outer circumferential surface of the sound cavity bracket 40, and the second main portion 223 may be fixed on an outer circumferential surface of the annular flange 2131. Fixing the first capacitance plate 220 by using the sound cavity bracket 40 and the annular flange 2131 in this way, not only saves a structure for supporting the first capacitance plate 220 and enables functional reuse of the sound cavity bracket 40 and the annular flange 2131 to improve space utilization inside the core housing 210, thereby reducing a size of the earphone 1, but also improves structural compactness and stability inside the core housing 210 simultaneously.

In some embodiments, as shown in FIG. 5 and FIG. 7 to FIG. 9, the first main portion 222 may include at least two first sub-main portions 2221 circumferentially bent and connected along a circumference of the sound cavity bracket 40. Such a configuration can enable an entire shape of the first main portion 222 to be adapted to a circumferential shape of the sound cavity bracket 40. Moreover, on one hand, bonding strength between the first main portion 222 and the sound cavity bracket 40 can be improved, so that the first main portion 222 occupies less space inside the core housing 210, thereby reducing an entire size of the earphone 1, and on the other hand, an area of the first capacitance plate 220 can be further increased to enlarge a detection region of the first capacitance plate 220, thereby improving detection sensitivity of the first capacitance plate 220.

Merely by way of example, as shown in FIG. 5 and FIG. 7 to FIG. 9, two first sub-main portions 2221 may be provided, and the two first sub-main portions 2221 may be arranged at an interval along the width direction Y. The two first sub-main portions 2221 may be circumferentially bent along the circumference of the sound cavity bracket 40, and two ends of the two first sub-main portions 2221 that are relatively far apart may abut against the sound cavity bracket 40, which can ensure detection sensitivity of the first capacitance plate 220 and reduce processing difficulty of the first capacitance plate 220. In other embodiments, to further improve detection sensitivity of the first capacitance plate 220, three, four, five, etc., first sub-main portions 2221 may be provided. The greater a count of the first sub-main portions 2221 is, the higher a degree of fitting and adaptation to the sound cavity bracket 40 may be, and the larger the area of the first capacitance plate 220 may be.

In some embodiments, fixing mechanisms (not shown in figures) corresponding to the at least two first sub-main portions 2221 may be disposed on the sound cavity bracket 40, and the fixing mechanisms fix the at least two first sub-main portions 2221 correspondingly, so that a connection relationship between the first main portion 222 and the sound cavity bracket 40 is more stable, thereby improving structural stability of the core housing 210.

In some embodiments, as shown in FIG. 5 and FIG. 7 to FIG. 9, the second main portion 223 includes at least two second sub-main portions 2231 circumferentially bent and connected along a circumference of the annular flange 2131.

Such a configuration can enable an entire shape of the second main portion 223 to be adapted to a shape of the annular flange 2131. Moreover, on one hand, bonding strength between the second main portion 223 and the annular flange 2131 can be improved, so that the second main portion 223 occupies less space inside the core housing 210, thereby reducing a size of the core housing 210, and on the other hand, an area of the first capacitance plate 220 can be further increased to enlarge a detection region of the first capacitance plate 220, thereby improving detection sensitivity of the first capacitance plate 220.

Merely by way of example, as shown in FIG. 5 and FIG. 7 to FIG. 9, two second sub-main portions 2231 may be provided, and the two second sub-main portions 2231 may be arranged at an interval along the width direction Y. The two second sub-main portions 2231 may be circumferentially bent along the circumference of an annular flange 2131, and two ends of the two second sub-main portions 2231 that are relatively far away from each other may abut against the annular flange 2131, which can ensure detection sensitivity of a first capacitance plate 220 and reduce processing difficulty of the first capacitance plate 220. In other embodiments, to further improve detection sensitivity of the first capacitance plate 220, three, four, five, etc., second sub-main portions 2231 may be provided. The greater a count of the second sub-main portions 2231 is, the higher a degree of fitting and adaptation to the annular flange 2131 may be, and the larger the area of the first capacitance plate 220 may be.

In some embodiments, fixing mechanisms (not shown in figures) corresponding to the at least two second sub-main portions 2231 may be disposed on the annular flange 2131, and the fixing mechanisms fix the at least two second sub-main portions 2231 correspondingly, so that a connection relationship between a second main portion 223 and the annular flange 2131 is more stable, thereby improving structural stability of the core housing 210.

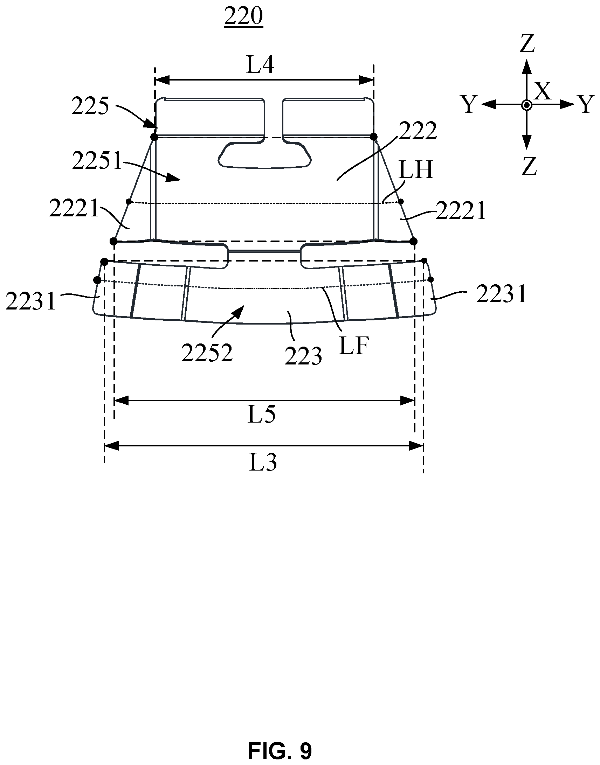

In some embodiments, as shown in FIG. 9, the first capacitance plate 220 may form a second projection 225 in a second reference plane perpendicular to the length direction X.

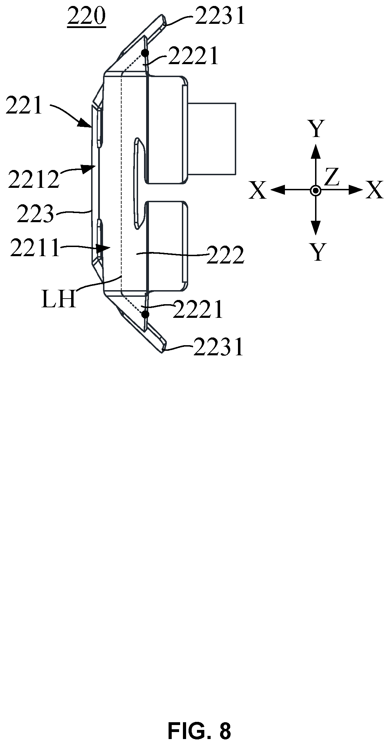

As shown in FIG. 8 and FIG. 9, the first projection 221 may include a first sub-projection area 2211 formed by the first main portion 222 and a second sub-projection area 2212 formed by the second main portion 223. The second projection 225 may include a third sub-projection area 2251 formed by the first main portion 222 and a fourth sub-projection area 2252 formed by the second main portion 223. An area of the first sub-projection area 2211 may be less than an area of the third sub-projection area 2251, and an area of the second sub-projection area 2212 may be less than an area of the fourth sub-projection area 2252.

In the wearing state, a side surface of the free end 212 along the thickness direction Z is closer to the auricle 102. Therefore, setting the area of the first sub-projection area 2211 to be less than the area of the third sub-projection area 2251 and setting the area of the second sub-projection area 2212 to be less than the area of the fourth sub-projection area 2252, can enable an entire size of the first projection 221 smaller than an entire size of the second projection 225, so that the first capacitance plate 220 has a larger area extending along the thickness direction Z and a smaller area extending along the length direction X, thereby facilitating detection by the first capacitance plate 220 of whether the free end 212 is in contact with or close to the auricle 102 or an inner wall of a concha cavity 1021, which can improve detection sensitivity of the first capacitance plate 220, reduce occurrence of accidentally touching phenomenon simultaneously, and improve detection accuracy of the first capacitance plate 220.

In some embodiments, as shown in FIG. 6, FIG. 8, and FIG. 9, when the first reference plane is translated along the thickness direction Z, the first reference plane and the first main portion 222 may form a first intersection line. Along a direction from the second side wall 214 toward the first side wall 213, a length of the first intersection line may gradually increase.

Merely by way of example, when the first reference plane is translated along the thickness direction Z to a certain position, the first intersection line may be shown by a line segment LH in FIG. 8 and FIG. 9. The first intersection line may exhibit various forms corresponding to a shape of the first main portion 222. If the first main portion 222 is arc-shaped, the first intersection line is also an arc line segment. If the first main portion 222 is in a bent form, the first intersection line is also a multi-segment bent line.

Specifically, the first main portion 222 is set as that the length of the first intersection line gradually increases in the direction from the second side wall 214 toward the first side wall 213, indicating that the first main portion 222 gradually widens along the direction from the second side wall 214 toward the first side wall 213. That is, a portion of the first main portion 222 closer to the first side wall 213 becomes wider as the first intersection line becomes longer.

When the user picks up the earphone 1, two fingers are typically used to pinch the core housing 210 along the width direction Y, and since the first side wall 213 is closer to the auricle 102 compared with the second side wall 214 in the wearing state, the two fingers of the user are closer to the second side wall 214. The first main portion 222 is set as that the length of the first intersection line gradually increases in the direction from the second side wall 214 toward the first side wall 213, enabling a width of a side of the first main portion 222 closer to the second side wall 214 to be slightly narrower than a width of a side closer to the first side wall 213, which ensures detection sensitivity of the first main portion 222 while reducing accidentally touching phenomenon when the user pinches the earphone 1, thereby improving detection accuracy of the first capacitance plate 220.

In some embodiments, as shown in FIG. 9, when the first reference plane is translated along the thickness direction Z, the first reference plane and the second main portion 223 form a second intersection line, and a minimum length of the second intersection line is not less than a minimum length of the first intersection line. The second intersection line may exhibit various forms corresponding to a shape of the second main portion 223. If the second main portion 223 is arc-shaped, the second intersection line is also an arc line segment. If the second main portion 223 is in a bent form, the second intersection line is also a multi-segment bent line.

Merely by way of example, the second intersection line may be shown by a line segment LF in FIG. 9, the minimum length of the second intersection line may be shown by a distance L3 in FIG. 9, and the minimum length of the first intersection line may be shown by a distance L4 in FIG. 9.

Specifically, since the second main portion 223 is closer to the first side wall 213 compared with the first main portion 222, the second main portion 223 is closer to the auricle 102 compared with the first main portion 222 in the wearing state, so that the user is more likely to touch the first main portion 222 when picking up the earphone 1. Setting the minimum length of the second intersection line to be not less than the minimum length of the first intersection line, makes the minimum length of the first intersection line closer to the second side wall 214 relatively narrow. That is, an entire size of the first main portion 222 is smaller, which can further reduce accidentally touching phenomenon when the user pinches the earphone 1. Simultaneously, a longer minimum length of the second intersection line indicates a larger entire size of the second main portion 223, which can ensure an entire size of the first capacitance plate 220, thereby ensuring detection sensitivity of the first capacitance plate 220.

In some embodiments, the minimum length of the second intersection line may be not less than a maximum length of the first intersection line.

Merely by way of example, the minimum length of the second intersection line may be shown by the distance L3 in FIG. 9, and the maximum length of the first intersection line may be shown by a distance L5 in FIG. 9. L3 is greater than L5.

Such a configuration can enable a width of the second main portion 223 closer to the first side wall 213 along the width direction Y is entirely greater than a width of the first main portion 222. In the wearing state, the second main portion 223 is closer to the auricle 102. Therefore, configuring the second main portion 223 with a larger width allows the second main portion 223 to have a larger area to implement the detection function, facilitating wearing detection, thereby improving detection sensitivity of the second main portion 223.

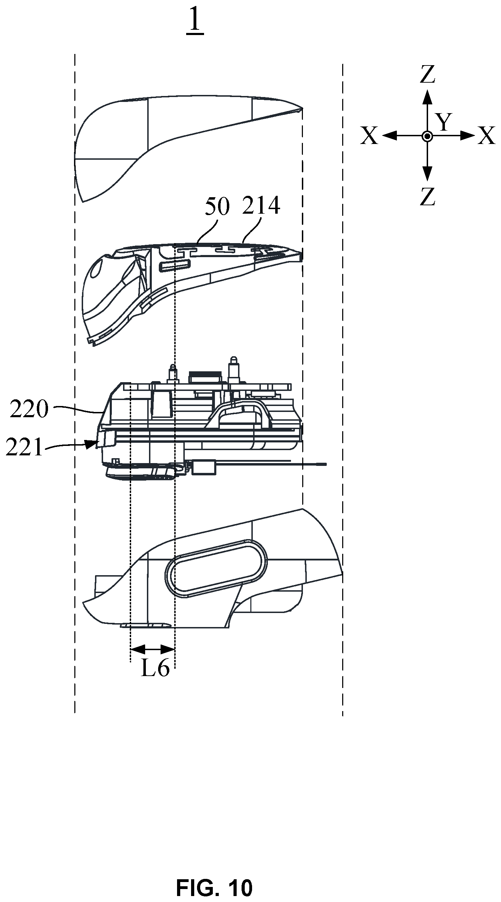

In some embodiments, as shown in FIG. 5 and FIG. 10, the earphone 1 may further include a second capacitance plate 50 disposed on the second side wall 214, and the second capacitance plate 50 is configured to generate a touch signal in response to a touch operation of the user. Merely by way of example, the second capacitance plate 50 may be located on a side of the second side wall 214 away from an interior of the core housing 210.

The second capacitance plate 50 may be a chip capacitance plate, which is a conversion device configured to convert a mechanical quantity (e.g., a resistance value change, a pressure change, etc.) upon contact with a human body into a capacitance change, and can generate the touch signal. The touch signal may be a control signal such as a song switching signal, a volume control signal, a power on/off signal, etc., which enables the user to control the earphone 1 to perform functions such as switching songs, controlling volume, or turning power on/off, etc., by touching the second capacitance plate 50.

In some embodiments, a spatial distance between the first capacitance plate 220 and the second capacitance plate 50 along the length direction X is not less than 4 mm. The spatial distance refers to a distance between a side of the first capacitance plate 220 closest to the connection end 211 and a side of the second capacitance plate 50 closest to the free end 212 along the length direction X, that is, the spatial distance is a minimum relative distance between the first capacitance plate 220 and the second capacitance plate 50.

Merely by way of example, the spatial distance between the first capacitance plate 220 and the second capacitance plate 50 may be shown by a distance L6 in FIG. 10. For example, the spatial distance L6 between the first capacitance plate 220 and the second capacitance plate 50 may be 4 mm, 4.25 mm, 5 mm, 5.5 mm, or other values.

If the spatial distance between the first capacitance plate 220 and the second capacitance plate 50 is less than 5 mm, the user is likely to touch the first capacitance plate 220 when touching the second capacitance plate 50, which results in accidentally touching phenomenon. Therefore, setting the spatial distance between the first capacitance plate 220 and the second capacitance plate 50 to be not less than 5 mm can reduce accidentally touching phenomenon, which enables detection by the first capacitance plate 220 and touch control by the second capacitance plate 50 more accurate, thereby improving the user experience.

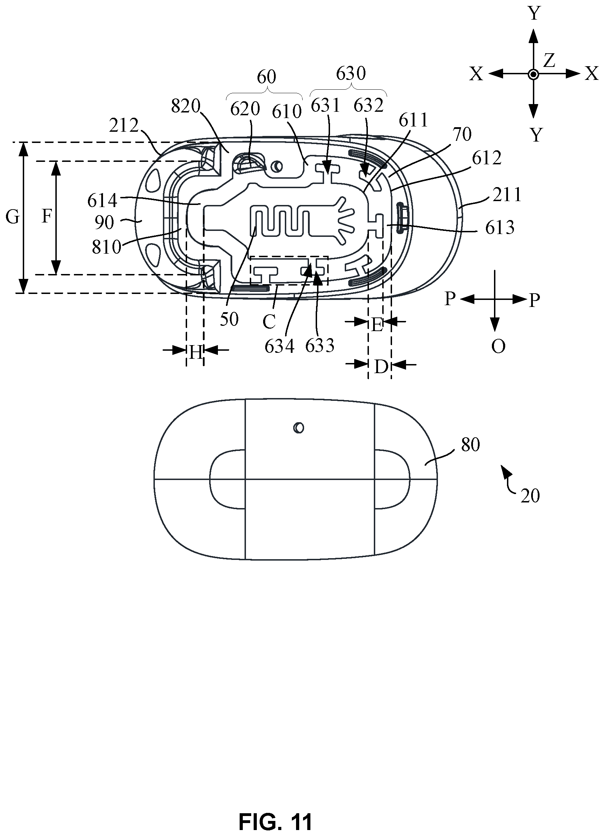

In some embodiments, as shown in FIG. 11, the earphone 1 may include an antenna 60 including a radiator 610 arranged in a ring shape and a feed point 620 disposed on the radiator 610. The feed point 620 is configured to receive a feed current, the feed current may form a first transmission current and a second transmission current that transmit in opposite directions along a circumferential direction of the radiator 610 on two sides of the feed point 620, and the first transmission current and the second transmission current may converge in the radiator 610.

The feed point 620 refers to an input interface for inputting the feed current into the radiator 610, which is capable of transmitting the feed current inside the earphone 1 to the radiator 610, and is also capable of efficiently converting a received electromagnetic wave signal into a radio frequency signal and transmitting the radio frequency signal into a control circuit inside the earphone 1. The feed current refers to a modulated high-frequency current in the earphone 1, which is capable of being transmitted into the radiator 610 via the feed point 620. The radiator 610 is capable of undergoing changes in electric field and magnetic field under the action of the feed current, and the electric field and the magnetic field interact with each other to generate an electromagnetic wave. The feed current may carry an electrical signal representing communication information of the earphone 1, and the earphone 1 may control the feed current to generate a corresponding electromagnetic wave, and then communicate with other electronic devices such as a mobile phone, a computer, etc., via the corresponding electromagnetic wave.

Specifically, configuring the radiator 610 in the ring shape, and configuring the feed current to form the first transmission current and the second transmission current that transmit in the opposite directions along the circumferential direction of the radiator 610 on the two sides of the feed point 620, can enable the feed current to disperse after entering the radiator 610. The configuration of dispersed current distribution can reduce strong points of the electric field in the radiator 610, thereby reducing the amount of radiation absorbed by human tissue and consequently reducing strong points of the electric field inside the human body. Moreover, configuring the first transmission current and the second transmission current to be opposite and to converge in the radiator 610 allows an electric field generated by the first transmission current and an electric field generated by the second transmission current to partially cancel each other out, which further reduces the electric field in the radiator 610, thereby enabling a lower amount of radiation energy absorbed by the internal tissues of the human body. In other words, the configuration of forming the first transmission current and the second transmission current that transmit in the opposite directions on both sides of the feed point 620 and the two currents capable of converging in the radiator 610, can reduce a SAR value within the radiator 610 and reduce the impact of electromagnetic wave from the earphone 1 on the human body. The SAR value represents electromagnetic power absorbed or consumed by a unit mass of human tissue.

In some embodiments, a convergence region of the first transmission current and the second transmission current may coincide with a 1/4 target wavelength transmission path starting from the feed point 620.

Merely by way of example, the convergence region of the first transmission current and the second transmission current may be shown by a region C in FIG. 11.

Specifically, after the first transmission current and the second transmission current enter the radiator 610 starting from the feed point 620, changes in the electric field and the magnetic field of the radiator 610 correspondingly happen, thereby generating the electromagnetic wave. Since the feed point 620 is typically a current strong point, but the target wavelength of the electromagnetic wave generated by the first transmission current and the second transmission current starting from the feed point 620 becomes a current weak point after traveling 1/4 path, setting the convergence region of the first transmission current and the second transmission current that transmit in the opposite directions to coincide with the 1/4 target wavelength transmission path, allows the electric field of the first transmission current and the electric field of the second transmission current to mutually balance the current weak point at the 1/4 target wavelength transmission path. Moreover, the first transmission current and the second transmission current have opposite transmission directions, which can enable electric fields in the convergence region to cancel each other out, thereby reducing the entire SAR value.

In some embodiments, the radiator 610 may include an inner ring edge 611 and an outer ring edge 612, and a hollow region 630 connected to the inner ring edge 611 and the outer ring edge 612 may be disposed on the radiator 610. Disposing the hollow region 630 connected to the inner ring edge 611 and the outer ring edge 612 on the radiator 610, can reduce a width of the radiator 610, thereby extending a transmission path of the feed current and dispersing current distribution, which in turn can reduce radiation energy in the radiator 610 to lower the SAR value, that is, reduce the impact of electromagnetic wave from the earphone 1 on the human body. In some embodiments, to better adapt the antenna 60 to a shape of the core housing 210 while reducing the SAR value of the antenna 60, the hollow region 630 on the radiator 610 may also be connected only to the inner ring edge 611 or only to the outer ring edge 612. Merely by way of example, as shown in FIG. 11, the hollow region 630 connected to the inner ring edge 611 and the outer ring edge 612 of the radiator 610 may be disposed on the radiator 610.

In some embodiments, the hollow region 630 may include a first hollow region 631 connected to the inner ring edge 611 of the radiator 610 and a second hollow region 632 connected to the outer ring edge 612 of the radiator 610. As shown in FIG. 11, the first hollow region 631 and the second hollow region 632 may be alternately arranged along a circumferential direction of the radiator 610. Such a configuration, not only can extend the transmission path of the feed current and further disperse current distribution to reduce the SAR value of the antenna 60, but also can balance stress distribution on a surface of the antenna 60, thereby avoiding the antenna breaking during processing or mounting as much as possible.

In some embodiments, as shown in FIG. 11, a ratio of a width of the hollow region 630 along a width direction of the radiator 610 to a width of the radiator 610 may be not greater than 1/2. For example, the ratio of the width of the hollow region 630 along the width direction of the radiator 610 to the width of the radiator 610 may be 2/5, 1/4, 1/3, 1/2, etc. The width direction of the radiator 610 refers to a direction perpendicular to an extension direction of the radiator 610, or a direction of a straight-line along a shortest line segment between the inner ring edge 611 and the outer ring edge 612 of the radiator 610.

Merely by way of example, an extension direction of the radiator 610 at a certain point may be shown by a direction O in FIG. 11, then the width direction of the radiator 610 may be shown by a direction P in FIG. 11, the width of the radiator 610 may be shown by a width D in FIG. 11, and the width of the hollow region 630 along the width direction P of the radiator 610 may be shown by a width E in FIG. 11.

If the ratio of the width of the hollow region 630 along the width direction of the radiator 610 to the width of the radiator 610 is set to be greater than 1/2, a radiation aperture of the antenna 60 is reduced, and bandwidth also becomes narrower, which affects radiation communication of the antenna 60. Therefore, setting the ratio of the width of the hollow region 630 along the width direction of the radiator 610 to the width of the radiator 610 to be not greater than 1/2, can ensure the radiation aperture of the antenna 60 while extending the transmission path of the feed current and reducing the SAR value, thereby avoiding the impact on radiation bandwidth as much as possible.

In some embodiments, the radiator 610 may include a hollow segment 613 and a strip segment 614 connected to each other along the circumferential direction of the radiator 610, wherein a bending degree of the strip segment 614 may be greater than that of the hollow segment 613, the hollow region 630 may be disposed on the hollow segment 613, and the hollow region 630 may be not disposed on the strip segment 614. A large bending degree of the strip segment 614 may be understood as the inner ring edge 611 or the outer ring edge 612 of the strip segment 614 having a large count of corners, to enable the strip segment 614 to exhibit multiple bends or even folds. Alternatively, a large bending degree of the strip segment 614 refers to the inner ring edge 611 or the outer ring edge 612 of the strip segment 614 having many abrupt changes in corner curvature.

Such a configuration can extend a length of the strip segment 614 within a limited space, thereby extending a current path of the feed current in the radiator 610. Furthermore, the strip segment 614 are less prone to breakage by not disposing the hollow region 630 on the strip segment 614, thereby enhancing firmness and reliability of the strip segment 614, reducing processing or mounting difficulty of the antenna 60, and improving entire reliability of the antenna 60.

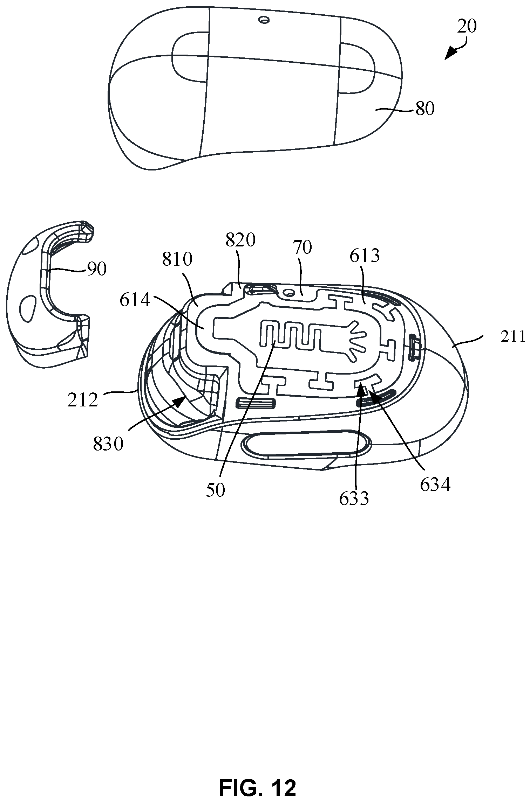

In some embodiments, as shown in FIG. 11 and FIG. 12, the earphone 1 may include a rigid housing 70 and a flexible covering layer 80, wherein the antenna 60 may be disposed on an outer surface of the rigid housing 70, the flexible covering layer 80 may cover the antenna 60 and the rigid housing 70, and the flexible covering layer 80 may be connected to the rigid housing 70 through the hollow region 630 on the radiator 610. The outer surface of the rigid housing 70 refers to a surface facing away from the auricle 102 of the user in the wearing state.

In some embodiments, the rigid housing 70 may form a portion of the core housing 210. For example, the rigid housing 70 may be a housing of the core housing 210 on a side away from the auricle 102 of the user in the wearing state. Alternatively, in some embodiments, the rigid housing 70 may form the entire core housing 210. Merely by way of example, the rigid housing 70 may form the entire core housing 210, and in this case, the antenna 60 may be disposed on a side of the second side wall 214 facing away from an interior of the core housing 210.

Specifically, disposing the antenna 60 on the rigid housing 70 can facilitate processing or mounting of the antenna 60 and also prevent the antenna 60 from shifting. Moreover, using the flexible covering layer 80 to wrap and cover the antenna 60 and the rigid housing 70 can further block impurities such as moisture, dust, metal particles, etc., from contacting the antenna 60, thereby ensuring communication performance of the antenna 60. The flexible covering layer 80 may be a soft covering layer such as silicone, etc.

Typically, if the antenna 60 is disposed between the rigid housing 70 and the flexible covering layer 80, a connection effect between the rigid housing 70 and the flexible covering layer 80 may be affected to some extent, which easily leads to issues such as bulging of the flexible covering layer 80. Therefore, the configuration of the hollow region 630 in the antenna 60 can allow a portion of the outer surface of the rigid housing 70 to be exposed in an area where the antenna 60 is disposed on the rigid housing 70, so that the flexible covering layer 80 can be connected to the rigid housing 70 through the exposed outer surface at the hollow region 630, which can improve connection strength between the rigid housing 70 and the flexible covering layer 80 when the antenna 60 is disposed between the rigid housing 60 and the flexible covering layer 80, thereby reducing issues such as bulging in the earphone 1.

In some embodiments, the rigid housing 70 and the flexible covering layer 80 may be adhered together by an adhesive such as glue, etc. Certainly, in other embodiments, the rigid housing 70 and the flexible covering layer 80 may also be connected by screws, snap fits, or other ways, which are not exhaustively listed here in the embodiments.

In some embodiments, as shown in FIG. 11 and FIG. 12, the second capacitance plate 50 may be disposed on the outer surface of the rigid housing 70, and may also be disposed at a central position surrounded by the ring-shaped radiator 610, so that the flexible covering layer 80 may also cover the second capacitance plate 50, and an adhesion position of the rigid housing 70 and the flexible covering layer 80 may be staggered from a position of the second capacitance plate 50. Such a configuration can fully utilize a space on the outer surface of the rigid housing 70 to improve space utilization of the earphone 1, and can also allow the flexible covering layer 80 to cover and protect the second capacitance plate 50, which further blocks impurities such as moisture, dust, metal particles, etc., from contacting the antenna 60, thereby reducing the occurrence of external impurities affecting a touch function of the second capacitance plate 50.

In some embodiments, an area of each hollow region 630 may be between 1.5 mm² and 4.5 mm². For example, the area of each hollow region 630 may be 1.5 mm², 1.8 mm², 1.9 mm², 2 mm², 2.5 mm², 3 mm², 4.2 mm², 4.5 mm², etc.

If the area of each hollow region 630 is less than 1.5 mm², a strong connection between the area where the antenna 60 is disposed on the rigid housing 70 and the flexible covering layer 80 is difficult to maintain, which results in an insufficiently firm connection between the rigid housing 70 and the flexible covering layer 80, thereby consequently causing issues such as bulging of the flexible covering layer 80. If the area of each hollow region 630 is greater than 4.5 mm², entire strength of the radiator 610 is poor, and since stress is relatively concentrated at the hollow region 630 in the radiator 610, the radiator 610 is prone to breakage after the hollow region 630 is formed.

Therefore, setting the area of each hollow region 630 between 1.5 mm² and 4.5 mm² not only enables the strong connection between the rigid housing 70 and the flexible covering layer 80, but also ensures communication performance of the antenna 60 and makes the antenna 60 firmer.

In some embodiments, along a width direction of Y the rigid housing 70, a size of a region of the rigid housing 70 that carries the strip segment 614 is less than a size of a region of the rigid housing 70 that carries the hollow segment 613, wherein the width direction Y is a direction in which the earphone 1 approaches or moves away from a top of a head in the wearing state.

Since the bending degree of the strip segment 614 is greater than that of the hollow segment 613, a length of the strip segment 614 can be extended within a limited space, and the current path of the feed current in the radiator 610 is extended. Compared with the size of the area of the rigid housing 70 that carries the hollow segment 613, the size of the area of the rigid housing 70 that carries the strip segment 614 can be set relatively small, which allows other electronic components to be disposed near the area of the rigid housing 70 where the strip segment 614 of the radiator 610 is disposed, thereby increasing space utilization of the core housing 210. Merely by way of example, the strip segment 614 may be disposed on a side of the rigid housing 70 close to the free end 212, and the first capacitance plate 220 may be disposed on the outer surface of the rigid housing 70 and partially surround the strip segment 614.

In some embodiments, as shown in FIG. 11 and FIG. 12, the earphone 1 may include a flexible insert block 90, and the rigid housing 70 may at least form a part of the core housing 210. In other words, the connection end 211 of the rigid housing 70 may be the connection end 211 of the core housing 210, and the free end 212 of the rigid housing 70 may be the free end 212 of the core housing 210. The area where the antenna 60 is disposed on the rigid housing 70 may be located between the connection end 211 and the free end 212, and the flexible insert block 90 may be embedded in the free end 212 of the rigid housing 70.

Disposing the flexible insert block 90 in the free end 212 of the rigid housing 70, allows the user's ear to contact the setting region of the earphone 1 where the flexible insert block 90 is disposed when the earphone 1 is in the wearing state and the free end 212 extends into the auricular cavity 1021 or abuts against the auricle 102 (e.g., abuts against the antihelix 1024 or the helix 1026) of the user, thereby improving user experience.

In some embodiments, the flexible insert block 90 may also be wrapped by the flexible covering layer 80, and the flexible insert block 90 abuts against the user's ear through the flexible covering layer 80, enabling the human body to contact a soft portion of the earphone 1 under the action of the flexible insert block 90 and the flexible covering layer 80, thereby improving user experience.

In some embodiments, the flexible insert block 90 may be made of a flexible material such as silicone, thermoplastic elastomer (TPE), etc.

In some embodiments, the rigid housing 70 may include a peninsula-shaped protruding portion 810 on a side close to the free end 212, a base portion 820 connected to the protruding portion 810 and close to the connection end 211, and a mounting portion 830 located around the protruding portion 810, and the flexible insert block 90 may be disposed on the mounting portion 830. With such a configuration, the flexible insert block 90 and the rigid housing 70 are mutually embedded, which enables a connection between the flexible insert block 90 and the rigid housing 70 to be more stable, thereby improving structural stability of the earphone 1.

Along the width direction Y of the rigid housing 70, a size of the protruding portion 810 may be less than a size of the base portion 820. The strip segment 614 may be at least partially located on the protruding portion 810, and the hollow segment 613 may be located on the base portion 820.

Merely by way of example, as shown in FIG. 11 and FIG. 12, the strip segment 614 is at least partially located on the protruding portion 810, this portion may form a shape with two extending ends and a protruding middle to adapt to the shape of the protruding portion 810, and two ends of the strip segment 614 are connected to the hollow segment 613 and the feed point 620, respectively. The size of the protruding portion 810 may be shown by a length F in FIG. 11, the size of the base portion 820 may be shown by a length G in FIG. 11, and G is greater than F.

The strip segment 614 is at least partially disposed on the protruding portion 810 with a relatively small size. The hollow segment 613 provided with the hollow region 630 is disposed on the base portion 820 having a relatively large size. Such a configuration can fully utilize bending characteristics of the strip segment 614 and hollowness characteristics of the hollow segment 613, and not only can avoid a position of the flexible insert block 90 on the outer surface of the rigid housing 70, but also can extend the current path as much as possible, thereby improving space utilization.

Certainly, in other embodiments, the flexible insert block 90 and the rigid housing 70 can be embedded in other manners. For example, a protruding part is disposed on the flexible insert block 90, a recessing part is disposed in the middle of the rigid housing 70, the protruding part and the recessing part are embedded with each other to connect the flexible insert block 90 and the rigid housing 70, and the strip segment 614 may be bent and extend on two sides of the recessing part to avoid the position of the flexible insert block 90, thereby extending the current path and improving space utilization. Certainly, the flexible insert block 90 and the rigid housing 70 may be connected in other manners, and the embodiments are not described in detail herein.

In some embodiments, a width of the hollow segment 613 may be greater than a width of the strip segment 614.

The width direction of the hollow segment 613 is perpendicular to an extension direction of the hollow segment 613, and the width direction of the strip segment 614 is perpendicular to an extension direction of the strip segment 614. The width of the hollow segment 613 may be consistent with a width of a portion of the radiator 610 provided with the hollow region 630. Merely by way of example, a width at a certain position of the hollow segment 613 may be shown by the width D in FIG. 11, and the width at the certain position of the strip segment 614 may be shown by a width H in FIG. 11.

Setting the width of the hollow segment 613 to be greater than the width of the strip segment 614, can fully utilize bending characteristics of the strip segment 614 and hollowness characteristics of the hollow segment 613, so as to facilitate conveniently disposing the hollow region 630 in the hollow segment 613, thereby increasing the current path of the hollow segment 613. Setting the width of the strip segment 614 to be relatively small, can enable the strip segment 614 to be fully bent, so as to obtain a longer current extension path, reduce the SAR value, and improve space utilization near a setting region of the strip segment 614.

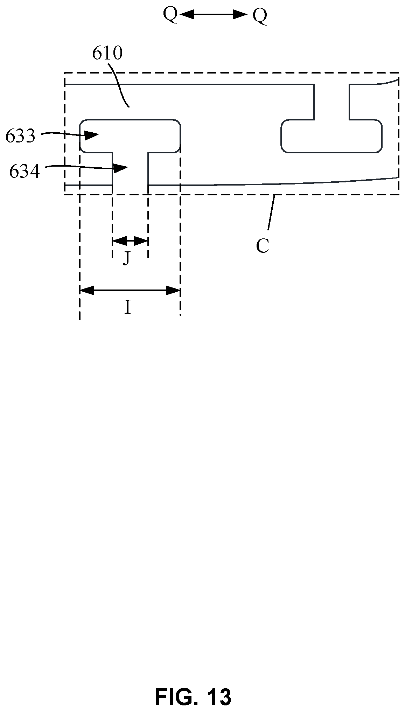

In some embodiments, as shown in FIG. 11 and FIG. 13, the hollow region 630 may include a main region 633 and a connection region 634, the main region 633 may be located inside the radiator 610, the connection region 634 may be connected between the main region 633 and the inner ring edge 611 or the outer ring edge 612, and an area of the connection region 634 is less than an area of the main region 633. Such a configuration can reduce processing difficulty of the hollow region 630 as much as possible, and ensure entire strength of the radiator 610.

In some embodiments, the connection region 634 of the first hollow region 631 may be connected to the main region 633 of the first hollow region 631 and the inner ring edge 611, and the connection region 634 of the second hollow region 632 may be connected to the main region 633 of the second hollow region 632 and the outer ring edge 612. Such a configuration can enable the first hollow region 631 and the second hollow region 632 to be alternately arranged, and can enable a current line of the radiator 610 to be transmitted in an "S" shape, thereby extending the current path in the radiator 610.

In some embodiments, a size of the main region 633 along a circumferential direction of the radiator 610 may be greater than a size of the connection region 634 along the circumferential direction of the radiator 610.

In some embodiments, the main region 633 and the connection region 634 may enable the hollow region 630 to be arranged in a T shape or a T-like shape.

The circumferential direction of the radiator 610 is the extension direction of the radiator 610 described above. Merely by way of example, a circumferential direction of the radiator 610 at a certain position may be shown by a direction Q in FIG. 13.

The connection area 634 may be located at a middle position of the main region 633 along the circumferential direction of the radiator 610 to enable the hollow region 630 in the T shape. Merely by way of example, the width of the main region 633 along the circumferential direction may be shown by I in FIG. 13, and the width of the connection region 634 along the circumferential direction may be shown by J in FIG. 13.

In other embodiments, the connection region 634 may be located at a left position or a right position relative to a central axis of the main region 633 along the circumferential direction of the radiator 610 to enable the hollow region 630 in the T-like shape.

Such a configuration can enable a path for transmitting the feed current in the radiator 610 longer, facilitate the antenna 60 being conveniently processed and formed, and enable the radiator 610 to be not prone to breakage at the hollow region, thereby improving the reliability of the antenna 60.

Certainly, in other embodiments, the hollow region 630 may be in other shapes (e.g., a circular shape, a triangular shape, a trapezoidal shape, an irregular shape, etc.), and the embodiments are not described in detail herein.

In summary, the core housing 210 of the earphone 1 described in the present disclosure is provided with the first capacitance plate 220, and the core housing 210 includes the free end 212 and the connection end 211 disposed along the length direction X, wherein the free end 212 extends into the concha cavity 1021 or abuts against the auricle 102, and the first capacitance plate 220 is disposed within a 5 equally divided region of the core housing 210 that is closest to the free end 212 along the length direction X. Such a configuration can enable the first capacitance plate 220 to be closer to the concha cavity 1021 or the user's auricle 102, to enable the first capacitance plate 220 to detect whether the free end extends into the concha cavity or abuts against the user's auricle more accurately, which can reduce the accidentally touching phenomenon when the user picks up the earphone, thereby reducing a probability of accident touch, so that the first capacitance plate can detect whether the earphone is in the wearing state more accurately, thereby improving the wearing experience of the user.

The foregoing descriptions are merely embodiments of the present disclosure. The patent scope of the present disclosure is not limited thereto. Equivalent structures or equivalent process transformations made based on the content of the specification and the accompanying drawings of the present disclosure, or direct or indirect applications in other related technical fields, are also included in the patent protection scope of the present disclosure.

## Claims

1. An earphone, comprising an ear hook and a sound production portion connected to each other, wherein
in a wearing state, the ear hook is hooked between an auricle and a head of a user, and the sound production portion is located at an anterior side of the auricle;
the sound production portion comprises a core housing and a first capacitance plate, the core housing including a connection end connected to the ear hook and a free end away from the connection end, wherein
at least a portion of the free end extends into a concha cavity or abuts against the auricle;
the first capacitance plate is disposed inside the core housing and at least a portion of the first capacitance plate is located at the free end; and
the first capacitance plate is configured to detect whether the earphone is in the wearing state; and
the core housing has a length direction, a width direction, and a thickness direction that are orthogonal to each other, the thickness direction being a direction in which the core housing faces toward or away from the auricle in the wearing state, the length direction being a direction in which the core housing is close to or far away from a back of the head in the wearing state, wherein
the first capacitance plate forms a first projection in a first reference plane perpendicular to the thickness direction; and
the first projection is located within a 5 equally divided region of the core housing that is closest to the free end along the length direction.

2. The earphone of claim 1, wherein the first projection is located within a 7 equally divided region of the core housing that is closest to the free end along the length direction.

3. The earphone of claim 1 or 2, wherein in the wearing state, at least a portion of the free end abuts against a helix of the auricle or an antihelix of the auricle.

4. The earphone of any one of claims 1-3, wherein
the first capacitance plate has a maximum distance from an outermost end of the free end along the length direction; and
a ratio of the maximum distance to an entire length of the core housing along the length direction is less than or equal to 0.2, the entire length being a distance from the free end to the connection end of the core housing.

5. The earphone of any one of claims 1-4, wherein
the core housing comprises a first side wall and a second side wall arranged at an interval along the thickness direction, wherein the first side wall is closer to the auricle than the second side wall in the wearing state;
the first capacitance plate comprises a first main portion, a second main portion, and a connecting portion, wherein
the second main portion is arranged at an interval from the first main portion along the thickness direction, and the second main portion is closer to the first side wall; and
the connecting portion connects the first main portion and the second main portion, and is bent such that the first main portion and the second main portion are arranged non-coplanar.

6. The earphone of claim 5, wherein the first capacitance plate forms a second projection in a second reference plane perpendicular to the length direction, wherein
the first projection comprises a first sub-projection area formed by the first main portion and a second sub-projection area formed by the second main portion; and
the second projection comprises a third sub-projection area formed by the first main portion and a fourth sub-projection area formed by the second main portion, wherein an area of the first sub-projection area is less than an area of the third sub-projection area, and an area of the second sub-projection area is less than an area of the fourth sub-projection area.

7. The earphone of claim 5 or 6, wherein
an annular flange is disposed on a side wall surface of the first side wall that is close to the first capacitance plate;
the earphone further comprises a speaker and a sound cavity bracket disposed inside the core housing;
the annular flange and the speaker cooperate to form an acoustic front cavity;
the sound cavity bracket and the speaker cooperate to form an acoustic rear cavity;
the first main portion is fixed on an outer circumferential surface of the sound cavity bracket; and
the second main portion is fixed on an outer circumferential surface of the annular flange.

8. The earphone of claim 7, wherein
the first main portion comprises at least two first sub-main portions circumferentially bent and connected along a circumference of the sound cavity bracket, and/or
the second main portion comprises at least two second sub-main portions circumferentially bent and connected along a circumference of the annular flange.

9. The earphone of any one of claims 5-8, wherein when the first reference plane is translated along the thickness direction, the first reference plane and the first main portion form a first intersection line, wherein along a direction from the second side wall toward the first side wall, a length of the first intersection line becomes longer.

10. The earphone of claim 9, wherein when the first reference plane is translated along the thickness direction, the first reference plane and the second main portion form a second intersection line, wherein a minimum length of the second intersection line is not less than a minimum length of the first intersection line.

11. The earphone of claim 10, wherein the minimum length of the second intersection line is not less than a maximum length of the first intersection line.

12. The earphone of any one of claims 5-11, wherein the earphone further comprises a second capacitance plate disposed on the second side wall, the second capacitance plate being configured to generate a touch signal in response to a touch operation of a user, wherein a spatial distance between the first capacitance plate and the second capacitance plate along the length direction is not less than 4 mm.
